**Europäisches Patentamt**

**European Patent Office**

**Office européen des brevets**

(19)

(11) Veröffentlichungsnummer: **0 046 263**
**B1**

(12) # EUROPÄISCHE PATENTSCHRIFT

(45) Veröffentlichungstag der Patentschrift:
**07.01.88**

(51) Int. Cl.⁴: **H 01 G 1/03,** H 05 K 5/02

(21) Anmeldenummer: **81106243.9**

(22) Anmeldetag: **11.08.81**

(54) **Gehäuse für elektrische Bauelemente.**

(30) Priorität: **20.08.80 DE 3031396**

(43) Veröffentlichungstag der Anmeldung:
**24.02.82 Patentblatt 82/8**

(45) Bekanntmachung des Hinweises auf die Patenterteilung:
**07.01.88 Patentblatt 88/1**

(84) Benannte Vertragsstaaten:
**BE DE FR IT SE**

(56) Entgegenhaltungen:
**DE - U - 7 539 984**
**FR - A - 2 286 966**
**GB - A - 568 715**
**GB - A - 1 553 053**

(73) Patentinhaber: **Alcatel N.V., De Lairessestraat 153, NL-1075 HK Amsterdam (NL)**
(84) Benannte Vertragsstaaten: **BE FR IT SE**

(73) Patentinhaber: **Standard Elektrik Lorenz Aktiengesellschaft, Hellmuth-Hirth-Strasse 42, D-7000 Stuttgart 40 (DE)**
(84) Benannte Vertragsstaaten: **DE**

(72) Erfinder: **Knoll, Peter, Lübecker Strasse 1, D-8510 Fürth (DE)**
Erfinder: **Maier, Werner Ludwig, Galvanistrasse 43, D-8500 Nürnberg (DE)**

(74) Vertreter: **Graf, Georg Hugo, Dipl.-Ing. et al, Standard Elektrik Lorenz AG Patent- und Lizenzwesen Postfach 30 09 29, D-7000 Stuttgart 30 (DE)**

**Beschreibung**

Die Erfindung bezieht sich auf Gehäuse für elektrische Bauelemente mit einem am Gehäuseboden angeformten Befestigungsbolzen, der so ausgebildet ist, dass damit das Gehäuse in einem Schlitz oder einer länglichen Ausnehmung einer Platte durch Einstecken und Verdrehen befestigbar ist.

Gehäuse, die elektrische Bauelemente, wie z.B. elektrische Kondensatoren, enthalten, sollen in möglichst einfacher Weise an einer geeigneten Grundplatte oder plattenförmigen Halterung befestigbar sein. Man hat hierzu das Gehäuse mit einem am Gehäuseboden angeformten Befestigungsbolzen versehen, auf den ein Gewinde geschnitten ist. Zur Befestigung des Gehäuses an einer Platte wird der Bolzen durch eine entsprechende Öffnung in der Platte gesteckt und auf der Plattenrückseite eine Mutter auf den Gewindebolzen aufgeschraubt. Für eine sichere und schüttelfeste Befestigung ist meist noch die Zwischenlage einer Unterlegscheibe und eines Federringes erforderlich.

Für eine solche Befestigung sind also zusätzlich zum Gehäuse noch weitere Teile erforderlich und ausserdem muss die Rückseite der Befestigungsplatte zugänglich sein. Schliesslich lässt sich ein so durch Verschrauben befestigtes Gehäuse nicht schnell auswechseln.

Ein Gehäuse für elektrische Bauelemente, das am Boden einen angeformten Bolzen trägt, mit dem das Bauelement durch einfaches Einstecken des Bolzens in den Schlitz einer Platte und Verdrehen befestigt werden kann, ist aus dem DE-GM 7 539 984 bekannt. Der Bolzen bei dieser Ausführungsform, bei der keine zusätzlichen Teile erforderlich sind und die Rückseite der Befestigungsplatte nicht zugänglich sein muss, hat zwei einander gegenüberliegende Abflachungen und am zylindrischen Teil anschliessend an den Gehäuseboden gleichsinnige keilförmige Ausnehmungen. Dadurch wird das in den Schlitz eingesteckte Bauelement beim Verdrehen auf der Platte festgeklemmt.

Es hat sich jedoch gezeigt, dass eine solche Klemmbefestigung nicht genügend rüttelfest ist und sich bei Erschütterungen leicht lockert und ausserdem ist die Herstellung der keilförmigen Ausnehmungen verhältnismässig aufwendig.

Aufgabe der Erfindung ist es, ein Gehäuse mit einem angeformten Befestigungsbolzen, mit dem es durch Verdrehen im Schlitz einer Platte befestigbar ist, zu schaffen, das eine rüttelfeste Befestigung ergibt und einfach und billig herstellbar ist.

Diese Aufgabe wird durch ein Gehäuse mit den Merkmalen des Kennzeichens von Anspruch 1 gelöst.

Vorteilhafte Weiterbildungen der Erfindung können den Unteransprüchen entnommen werden.

Die Erfindung soll anhand der Figuren beschrieben werden.

Figur 1 zeigt einen Teil des Gehäuses, das auf einer Platte befestigt ist, im Schnitt.

Figur 2 zeigt die Anordnung nach Figur 1 von der Rückseite der Platte her.

In den Figuren 3 und 4 sind Schnitte durch die Anordnung nach Figur 1 in der Plattenebene dargestellt, und zwar in Figur 3 vor dem Verdrehen und in Figur 4 nach dem Verdrehen des Gehäuses.

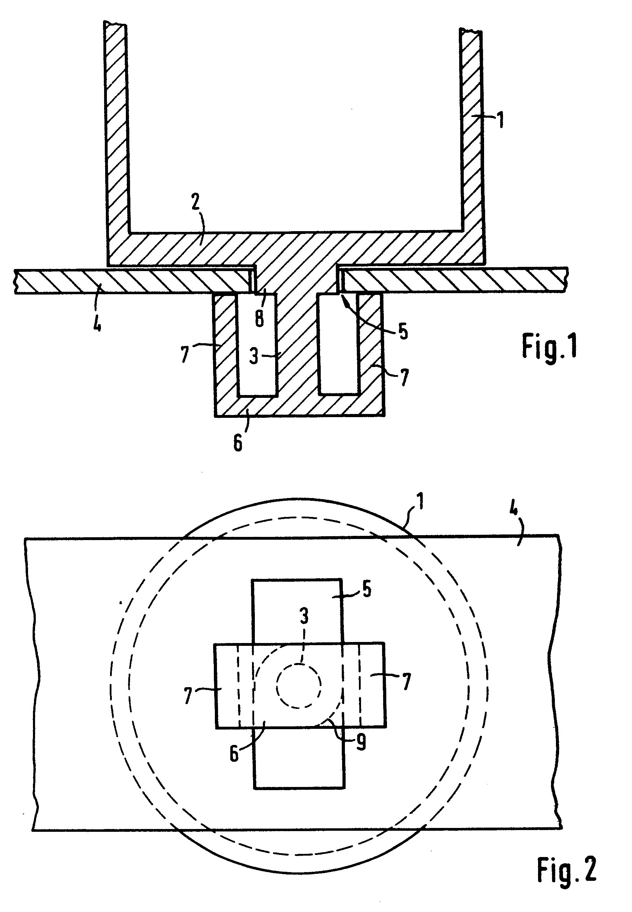

In den Figuren 1 und 2 ist ein Gehäuse 1 für ein elektrisches Bauelement, beispielsweise einen elektrischen Kondensator, dargestellt, das zylindrisch ausgebildet ist. Das Gehäuse 1 kann aber auch jede beliebige andere Form haben. Am Boden 2 des Gehäuses 1 ist ein Befestigungsbolzen 3 angeformt, der in bekannter Weise dazu dient, das Gehäuse 1 im Schlitz 5 einer Platte 4 zu befestigen.

Um eine einfache und rüttelsichere Befestigung zu erzielen, sind an den Befestigungsbolzen 3 gemäss der Erfindung federnde Lappen 7 angeformt, die, wie aus den Figuren ersichtlich, nach dem Verdrehen des Gehäuses 1 an der Rückseite der Platte 4 anliegen, so dass auch beim Einwirken von Erschütterungen das Gehäuse in seiner befestigten Lage verbleibt. Zweckmässig sind die Lappen 7 an einer rechteckigen Verbreiterung 6 angeformt, die am freien Ende des Bolzens 3 befestigt ist. Die Federwirkung wird durch Material und Dickenbemessung der Lappen 7 und/oder der Platte 6 erzielt. Wie aus Figur 2 ersichtlich, ist die Platte 6 so ausgebildet, dass sie durch den länglichen Schlitz 5 hindurchgesteckt werden kann und nach dem Verdrehen um 90°, wie dies in Figur 2 dargestellt ist, die federnden Lappen 7 von der Rückseite her an der Platte 4 anliegen.

Um ein leichteres Auflaufen der Lappen 7 auf den Rand des Schlitzes 5 der Platte 4 beim Verdrehen des Gehäuses zu erzielen, können die Lappen 7 an ihren freien Enden in Drehrichtung abgeschrägt sein.

Um ein Verdrehen des Gehäuses über einen Winkel von etwa 90° zu verhindern, ist der Bolzen 3 an dem am Gehäuseboden angeformten Ende mit einem Verdrehanschlag versehen. Dieser Verdrehanschlag ist so ausgebildet, dass er nur ein Verdrehen des Gehäuses um 90° gestattet.

Der Verdrehanschlag besteht vorteilhafterweise aus einer Verdickung 8 des Bolzens von etwa der Breite des Schlitzes 5 in der Platte 4. Diese Verdickung hat etwa quadratischen Querschnitt, bei dem zwei diagonal gegenüberliegende Ecken 9 abgerundet sind, wobei die Abrundung nach dem eingeschriebenen Kreis des Quadrats erfolgt.

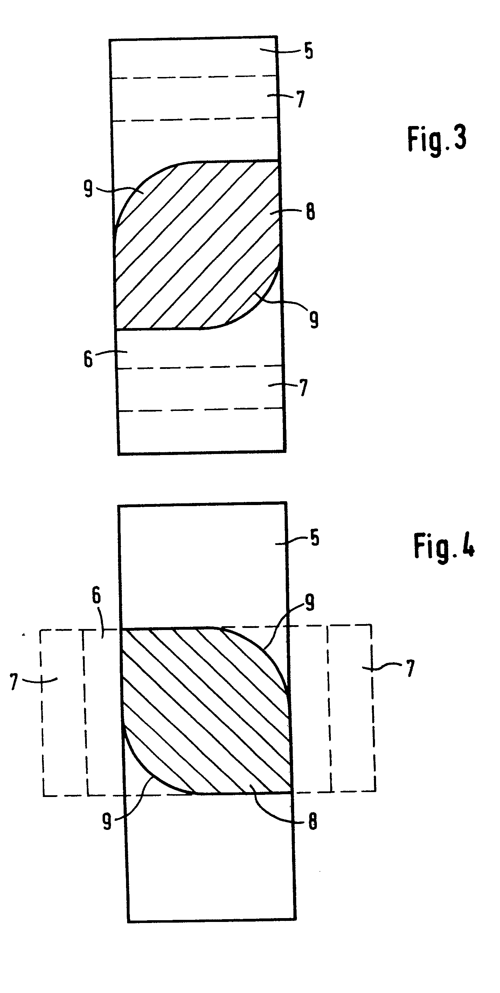

Zur Verdeutlichung der Form und Wirkungsweise der Verdickung 8 ist in den Figuren 3 und 4 ein Schnitt durch die Anordnung von Figur 1 in der Ebene der Platte 4 dargestellt, wobei in Figur 3 die Lage vor dem Verdrehen und in Figur 4 die Lage nach dem Verdrehen dargestellt ist.

Aus den Figuren 3 und 4 ist der Querschnitt der Verdickung 8 mit den beiden gegenüberliegenden Abrundungen 9 deutlich erkennbar. Gleichzeitig ist gestrichelt die Lage der an die Verbreiterung 6 angeformten Lappen 7 bezüglich des Schlitzes 5 dargestellt.

In der in Figur 3 dargestellten Lage wird der Bolzen 3 mit den angeformten Lappen 7 durch den Schlitz 5 hindurchgesteckt. Dann wird das Gehäuse im Gegensinne des Uhrzeigers um 90° verdreht, wobei sich die in Figur 4 dargestellte Lage ergibt. Die Abrundungen 9 ermöglichen ein Verdrehen, wobei die verbliebenen diagonalen Ecken einen Anschlag am Rand des Schlitzes 5 bilden, so dass ein weiteres Verdrehen nicht mehr möglich ist. Die gestrichelt dargestellten Lappen 7, die an die Verbreiterung 6 angeformt sind, liegen dann, wie aus Figur 4 ersichtlich, an der Rückseite der Platte 4 federnd an und ergeben die rüttelfeste Befestigung. Der Verdrehanschlag, der durch die Verbreiterung 8 gebildet wird, sorgt dafür, dass nach dem Verdrehen die Lappen 7 in der optimalen Lage sind.

Zweckmässig ist das Gehäuse mit dem Bolzen und den Lappen als einstückig geformtes Kunststoffteil hergestellt, wobei die Dicke der Lappen 7 und/oder der Verbreiterung 6 so bemessen sind, dass die erforderlichen Federeigenschaften vorhanden sind.

Ein solches Gehäuse lässt sich durch einfaches Einstecken und Verdrehen im Schlitz einer Platte leicht auswechselbar befestigen, wobei die Befestigung gegen Erschütterungen unempfindlich ist.

## Patentansprüche

1. Gehäuse für elektrische Bauelemente mit einem am Gehäuseboden angeformten Befestigungsbolzen, der so ausgebildet ist, dass damit das Gehäuse in einem Schlitz oder einer länglichen Ausnehmung einer Platte durch Einstecken und Verdrehen befestigbar ist, dadurch gekennzeichnet, dass am freien Ende des Bolzens (3) federnde Lappen (7) angeordnet sind, die nach dem Verdrehen des Gehäuses (1) an der Rückseite der Platte (4) anliegen.

2. Gehäuse nach Anspruch 1, dadurch gekennzeichnet, dass der Bolzen (3) am freien Ende eine rechteckige Verbreiterung (6) hat, an deren Enden gegen den Gehäuseboden (2) gerichtete Lappen (7) angeformt sind.

3. Gehäuse nach Anspruch 1 oder 2, dadurch gekennzeichnet, dass die Lappen (7) parallel zum Bolzen (3) verlaufen.

4. Gehäuse nach einem der Ansprüche 1 bis 3, dadurch gekennzeichnet, dass die Lappen (7) an ihren freien Enden in Drehrichtung abgeschrägt sind.

5. Gehäuse nach einem der Ansprüche 1 bis 4, dadurch gekennzeichnet, dass der Bolzen (3) an dem am Gehäuseboden (2) angeformten Ende einen Verdrehanschlag (8) hat, der im Schlitz (5) der Platte (4) ein Verdrehen um nur 90° gestattet.

6. Gehäuse nach Anspruch 5, dadurch gekennzeichnet, dass der Verdrehanschlag aus einer Verdickung (8) des Bolzens (3) von etwa der Breite des Schlitzes (5) in der Platte (4) mit etwa quadratischem Querschnitt besteht, bei dem zwei diagonal gegenüberliegende Ecken (9) nach dem eingeschriebenen Kreis des Quadrates abgerundet sind.

7. Gehäuse nach einem der Ansprüche 1 bis 6, dadurch gekennzeichnet, dass das Gehäuse (1) und der Bolzen (3) mit der Verbreiterung (6) und dem daran angeformten Lappen (7) sowie mit seiner Verdickung (8) aus einem einstückig geformten Kunststoffteil bestehen.

## Claims

1. Housing for electrical components with a securing bolt moulded onto the floor of the housing, which bolt is so designed as to enable the housing to be secured in a slot or elongated recess in a plate by inserting and twisting it, characterized in that the free end of the bolt (3) has on it spring lugs (7) which, after the housing (1) has been twisted, lie against the rear of the plate (4).

2. A housing as claimed in Claim 1, characterized in that the bolt (3) has at its free end a rectangular widening (6) on the ends of which lugs (7) directed towards the floor (2) of the housing are moulded.

3. A housing as claimed in Claim 1 or 2, characterized in that the lugs (7) run parallel to the bolt (3).

4. A housing as claimed in any one of Claims 1 to 3, characterized in that the lugs (7) are bevelled in the direction of rotation at their free ends.

5. A housing as claimed in any one of Claims 1 to 4, characterized in that the bolt (3) has, at the end moulded to the floor (2) of the housing, an anti-twist stop (8) which allows only 90° rotation in the slot (5) in the plate (4).

6. A housing as claimed in Claim 5, characterized in that the anti-twist stop consists of a thickening (8) of the bolt (3) of approximately the width of the slot (5) in the plate (4) with an approximately square cross-section, on which two diagonally opposite corners (9) are rounded according to the inscribed circle of the square.

7. A housing as claimed in any one of Claims 1 to 6, characterized in that the housing (1) and the bolt (3) with the widening (6) and the lug (7) moulded onto it, together with its thickening (8), consist of a plastic part moulded as a single piece.

## Revendications

1. Boîtier pour composants électriques, comprenant une tige de fixation moulée au fond du boîtier et conçue de manière qu'ainsi le boîtier puisse être monté dans une fente ou une ouverture allongée d'une plaque, par insertion puis rotation, caractérisé en ce que des languettes élastiques (7) sont arrangées à l'extrémité libre de la tige (3), ces languettes, après la rotation du boîtier (1), étant appliquées contre la face arrière de la plaque (4).

2. Boîtier conforme à la revendication 1, caractérisé en ce que ladite tige (3) est pourvue, à son extrémité libre, d'un élargissement rectangulaire (6), aux extrémités duquel sont formées les languettes (7) dirigées vers le fond (2) du boîtier.

3. Boîtier conforme à la revendication 1 ou 2, caractérisé en ce que lesdites languettes (7) s'étendent parallèlement par rapport à la tige (3).

4. Boîtier conforme à l'une quelconque des revendications 1 à 3, caractérisé en ce que lesdites languettes sont chanfreinées à leurs extrémités libres, dans le sens de la rotation.

5. Boîtier conforme à l'une quelconque des revendications 1 à 4, caractérisé en ce que ladite tige, en son extrémité moulée sur le fond (2) du boîtier, est pourvue d'une butée de rotation (8), de sorte que la tige (3) insérée dans la fente (5) prévue dans la plaque (4) ne peut effectuer qu'une rotation de 90°.

6. Boîtier conforme à la revendication 5, caractérisé en ce que cette butée consiste en un épaississement (8) de la tige (3) s'étendant presque à la largeur de ladite fente (5) dans la plaque (4), de section presque carrée, dont deux coins opposés (9) sont arrondis en suivant le cercle inscrit dans le carré.

7. Boîtier selon l'une quelconque des revendications 1 à 6, caractérisé en ce que le boîtier (1) et la tige (3), de même que l'élargissement (6) et les languettes (7) formées sur celui-ci, ainsi que son épaississement (8) consistent en une seule pièce de matière plastique moulée.

Fig.1

Fig.2

Fig.3

Fig.4